# EUROPÄISCHE PATENTSCHRIFT

(11) **EP 0 863 051 B1**
(45) Veröffentlichungstag und Bekanntmachung des Hinweises auf die Patenterteilung: **25.07.2001**
(21) Anmeldenummer: 98103751.8
(22) Anmeldetag: 04.03.1998
(51) Int. Cl.: B60R 11/02, H03J 1/22

(54) **Abnehmbares Bedienteil mit einem Inkrementgeber**
Removable control module with increment action
Module de commande avec action à incrément

(30) Priorität: 08.03.1997 DE 19709616
(43) Veröffentlichungstag der Anmeldung: 09.09.1998
(73) Patentinhaber: GRUNDIG Aktiengesellschaft, 90471 Nürnberg (DE)
(72) Erfinder: Ritter, Kai-Uwe, 90762 Fürth (DE)

(56) Entgegenhaltungen:
- DE-U- 9 412 197
- US-A- 3 559 144
- US-A- 4 398 144
- US-A- 4 820 914
- US-A- 5 513 268

## Beschreibung

Die Erfindung betrifft ein abnehmbares Bedienteil mit einem Inkrementgeber, mit den Merkmalen des Oberbegriffs nach Anspruch 1.

In Autoradios werden abnehmbare Bedienteile verwendet, die einen Inkrementgeber für die Einstellung verschiedener Parameter, zum Beispiel der Lautstärke, aufweisen. Der Inkrementgeber wird üblicherweise von zwei Schaltern gebildet, die bei der Drehung des Inkrementgebers um 90° versetzte Schaltzustände einnehmen, wodurch sich der Drehwinkel und die Drehrichtung bestimmen lassen. Zusätzlich kann ein Schalter als Bestätigungselement vorhanden sein, der durch Druck auf den Knopf des Inkrementgebers betätigt wird. Zur Überprüfung, ob sich das abnehmbare Bedienteil im Autoradio befindet, ist ein weiterer Kontakt vorgesehen, an den beispielsweise ein Widerstand angeschlossen ist. Alle Schalter bzw. der Widerstand sind über einen Massekontakt angeschlossen.

Somit weist das abnehmbare Bedienteil zwei Kontakte für den Inkrementgeber, einen Kontakt für das Bestätigungselement, einen Kontakt für den Widerstand und einen Massekontakt, insgesamt also fünf Kontakte auf. Ein derartiges abnehmbares Bedienteil wird beispielsweise bei dem von der Anmelderin hergestellten und unter der Bezeichnung EC 4000 RDS vertriebenen Autoradio eingesetzt.

Wegen der großen Anzahl der Kontakte tritt das Problem auf, daß das abnehmbare Bedienteil nicht rotationssymmetrisch gestaltet werden kann, weshalb das Einsetzen des abnehmbaren Bedienteils in das zugehörige Autoradio erschwert wird, weil es nur in einer bestimmten Stellung möglich ist.

Aufgabe der vorliegenden Erfindung ist es deshalb, ein abnehmbares Bedienteil anzugeben, das bei gleicher Funktionalität mit weniger Kontakten auskommt.

Diese Aufgabe wird durch die Merkmale des Anspruchs 1 gelöst.

Der Vorteil des erfindungsgemäßen abnehmbaren Bedienteils ist, daß mit nur zwei Kontakten die Funktionalität des bekannten abnehmbaren Bedienteils erreicht werden kann.

Weitere Vorteile der Erfindung ergeben sich aus den abhängigen Ansprüchen und der nachfolgenden Beschreibung anhand einer Figur.

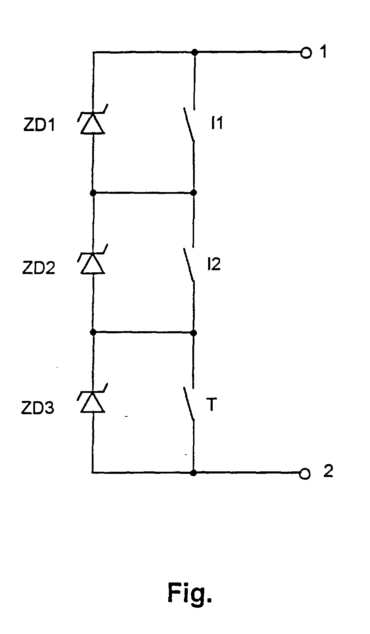

Die einzige Figur zeigt den elektrischen Aufbau eines erfindungsgemäßen abnehmbaren Bedienteils.

Die Figur zeigt drei Zenerdioden ZD1, ZD2 und ZD3 sowie drei Schalter I1, I2 und T. Jeweils zu einer der Zenerdioden ZD1, ZD2 bzw. ZD3 ist einer der Schalter I1, I2 bzw. T parallel geschaltet. Die parallel geschalteten Zenerdioden und Schalter ZD1, I1; ZD2, 12 und ZD3, T sind hintereinander geschaltet, wodurch sich insgesamt eine leiterförmige Struktur ergibt, an deren Enden sich zum Anschluß Kontakte 1 und 2 befinden. Die Kontakte 1 und 2 stellen die Verbindung zum zugehörigen Autoradio her, wenn das abnehmbare Bedienteil in das Autoradio eingesetzt ist. Über den Kontakt 1 liegt Masse an, über den Kontakt 2 liegt eine Betriebsspannung an.

Die Zenerdioden ZD1, ZD2 und ZD3 weisen unterschiedliche Zenerspannungen auf, wobei die Summe der Zenerspannungen kleiner als die Leerlaufspannung der an Kontakt 1 anliegenden Betriebsspannung sein muß.

Die Betriebspannung kann über einen Widerstand am Kontakt 1 anliegen. Dann ergeben sich an Kontakt 1 Strom- und Spannungsverhältnisse, die bei eingesetztem abnehmbaren Bedienteil vom Zustand der Schalter I1, I2 und T abhängen. Sind alle Schalter I1, I2 und T geöffnet, ergibt sich die Spannung als Summe der drei Zenerspannungen. Wird das abnehmbare Bedienteil entfernt, ergibt sich die Leerlaufspannung der Betriebsspannung. Entsprechend ergibt sich die Spannung bei der Betätigung eines der Schalter aus der Summe der Zenerspannungen der Zenerdioden, die parallel zu den anderen, nicht betätigten Schaltern liegen usw.

Statt der Zenerdioden ZD1, ZD2 und ZD3 können auch Widerstände verwendet werden, die so dimensioniert sein müssen, daß sich deutlich unterschiedliche Spannungspegel ergeben.

Die unterschiedlichen Spannungspegel, die sich beim Drehen des Inkrementgebers (Schalter I1, I2), beim Betätigen des Bestätigungselements (Schalter T), oder bei nicht eingesetztem abnehmbaren Bedienteil ergeben (kein Stromfluß über den Widerstand), werden im Autoradio ausgewertet. Dies kann beispielsweise mittels eines A/D-Wandlers und eines Mikrocomputers erfolgen. Der Mikrocomputer überwacht dabei ständig die am Kontakt 2 anliegende Spannung, die vom A/D-Wandler in ein digitales Signal umgewandelt wird.

Zur Verringerung der zur Überwachung des anliegenden Spannungspegels nötigen Rechenleistung des Mikrocomputers ist es vorteilhaft, wenn die anliegende Spannung differenziert wird. Übersteigt der ermittelte Diffemzwert eine vorgegebene Schwelle, wird ein Impuls erzeugt, der dem Mikrocomputer zugeführt wird. Der Mikrocomputer bestimmt daraufhin den anliegenden Spannungspegel und ermittelt damit welcher der Schalter I1, I2 und/oder T betätigt wurde.

## Patentansprüche

1. Abnehmbares Bedienteil mit einem Inkrementgeber, mit den Inkrementgeber bildenden Schaltmitteln (11,12) und weiteren Schaltmitteln (T),
**dadurch gekennzeichnet,**
daß die Schaltmittel (I1,I2,T) in Reihe geschaltet sind, und daß parallel zu den Schaltmitteln (I1,I2,T) in Reihe geschaltete Mittel (ZD1,ZD2,ZD3) geschaltet sind, an denen beim Anlegen einer Betriebsspannung eine definierte Spannung abfällt.

2. Abnehmbares Bedienteil nach Anspruch 1,
**dadurch gekennzeichnet,**
daß die Mittel (ZD1,ZD2,ZD3), an denen beim Anlegen einer Betriebsspannung eine definierte Spannung abfällt, Zenerdioden sind.

3. Abnehmbares Bedienteil nach Anspruch 1 oder 2,
**dadurch gekennzeichnet,**
daß das abnehmbare Bedienteil in einem Autoradio verwendet wird.

## Claims

1. Removable operating module having an increment generator, having switching means (I1, I2) forming the increment generator and further switching means (T), characterized
in that the switching means (I1, I2, T) are connected in series, and
in that series-connected switched means (ZD1, ZD2, ZD3) across which a defined voltage drops when an operating voltage is applied are connected in parallel with the switching means (I1, I2, T).

2. Removable operating module according to Claim 1, characterized
in that the means (ZD1, ZD2, ZD3) across which a defined voltage drops when an operating voltage is applied are Zener diodes.

3. Removable operating module according to Claim 1 or 2, characterized
in that the removable operating module is used in a car radio.

## Revendications

1. Unité de commande amovible comportant un générateur incrémentiel, des moyens de commutation (I1, I2) formant le générateur incrémentiel, et d'autres moyens de commutation (T), caractérisé en ce que les moyens de commutation (I1, I2, T) sont branchés en série et qu'en parallèle avec les moyens de commutation (I1, I2, T) sont branchés en série des moyens commutés (ZD1, ZD2, ZD3), dans lesquels une tension définie chute lors de l'application d'une tension de fonctionnement.

2. Unité de commande amovible selon la revendication 1, caractérisée en ce que les moyens (ZD1,ZD2,ZD3), dans lesquels une tension définie chute lors de l'application d'une tension de fonctionnement, sont des diodes Zener.

3. Unité de commande amovible selon la revendication 1 ou 2, caractérisée en ce que l'unité de commande amovible est utilisée dans un autoradio.
